(19) Europäisches Patentamt

European Patent Office

Office européen des brevets

(11) **EP 1 463 197 B1**

(12) **EUROPEAN PATENT SPECIFICATION**

(45) Date of publication and mention
of the grant of the patent:
**18.10.2006 Bulletin 2006/42**

(51) Int Cl.:
***H03F 1/02*** (2006.01)

(21) Application number: **04004980.1**

(22) Date of filing: **03.03.2004**

(54) **A device and method for measuring dependency of output power and for generating a ramp signal for a power amplifier**

Schaltungsanordnung und Verfahren zur Messung der Abhängigkeit der Ausgangsleistung und zur Erzeugung eines Rampensignals für einen Leistungsverstärker

Dispositif et procédé de mesure de la dépendance de la puissance de sortie et pour engendrer un signal de rampe dans un amplificateur de puissance

(84) Designated Contracting States:
**DE ES FR GB**

(43) Date of publication of application:
**29.09.2004 Bulletin 2004/40**

(73) Proprietor: **BenQ Mobile GmbH & Co. OHG**
**81667 Munich (DE)**

(72) Inventor: **Langer, Andreas**
**85716 Unterschleissheim-Lohhof (DE)**

(56) References cited:
**WO-A-02/47249**        **WO-A-03/073627**
**US-A- 6 043 707**       **US-A1- 2003 176 170**

**Description**

**Field of the invention**

The invention relates to power control in general, and, more specifically, to a device and method for obtaining information about the performance of the power amplifier, and further to generating an up- or down ramp for a power amplifier.

**Background of the invention**

In mobile communications, power amplifiers are used to amplify microwave signal. The technical specifications set strict requirements to transmitter performance, regarding output power and allowed transient spectrum.
In some prior power control solutions, the output power of a power amplifier is detected by using a coupler and a detector. The detector is calibrated and compensated for temperature changes. The compensation of temperature effects is performed with hardware or with correction tables stored in the mobile terminal. If the detected power is below a target value, the power is increased for the next burst. In the opposite case, the power is decreased accordingly. The correction is thus performed from burst to burst.
A similar solution is disclosed in US patent 6 307 429 where an extended power ramp table for a power amplifier control loop in a time division multiple access communication system includes a power profile data table and a control data table. The power profile data are used to control transition of the power amplifier circuit between its on and off states to minimize the number and power levels of spurious and other undesired signals generated by such on and off circuit state transitions. The control data are used to programmably control performance characteristics of the control loop for the power amplifier circuit.

**Summary of the invention**

An objective of the invention is to improve a device and method for measuring dependency of output power of a power amplifier on control voltage. This objective of the invention can be achieved as set out in independent claims 1 and 7.
Dependent claims 2 to 4 and 8 to 10 describe various advantageous embodiments of the first objective of the invention.
A second objective of the invention is to improve the device and method for generating an up- or down-ramp for a power amplifier. This objective of the invention can be achieved as set out in independent patent claims 5 and 11.
Dependent claims 6 and 12 describe advantageous embodiments of the second objective of the invention.

**Advantages of the invention**

An advantage of the first objective of the invention is that the transfer characteristic of the power amplifier can be obtained based on the actual up- or down-ramping. This information is very useful in making decisions about controlling the transmitter.
When the predefined mapping rule is adapted to use an estimate for dependency of the detected output power on the key value, the output power can be detected below the dynamic range of the means for receiving the voltage or of the converting means.
The saturation of the power amplifier can be detected by comparing an estimated dependency of the detected output power on the key value with a predefined threshold value. In this manner, the saturation range can be avoided, thereby increasing the power efficiency and improving the transient spectrum of the transmitter.
A further advantage of the second objective of the invention is that the performance of a power amplifier can be improved close to the start-up power range and close to the saturation power.
The method and device can be used in any power amplifier, because the characteristic is always determined, and, key values responsive to the power values of an up- or down-ramp are computed.
The method and device are robust, because both behavior in saturation and power-up range are taken into account. It is not too complicated and thus easily implementable, because only one coupler, one detector, such as a diode, and one Analog-to-Digital Converter ADC are necessary.

**Short description of the drawings**

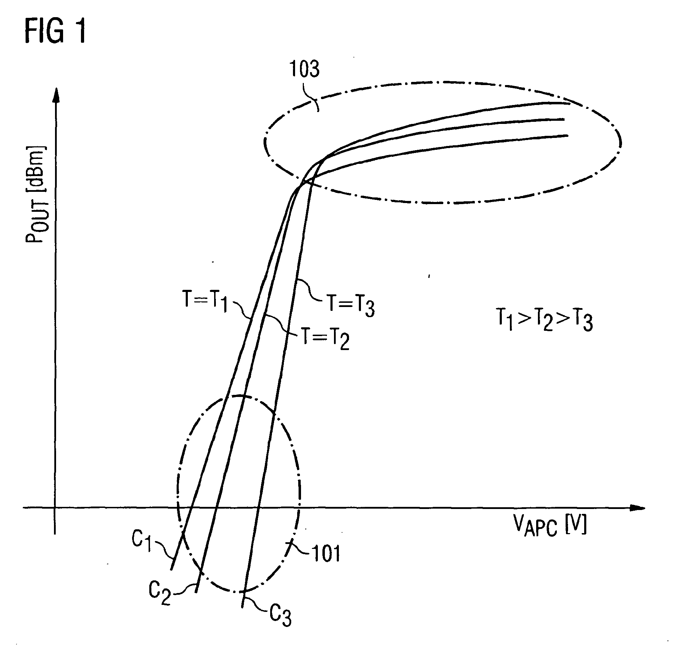

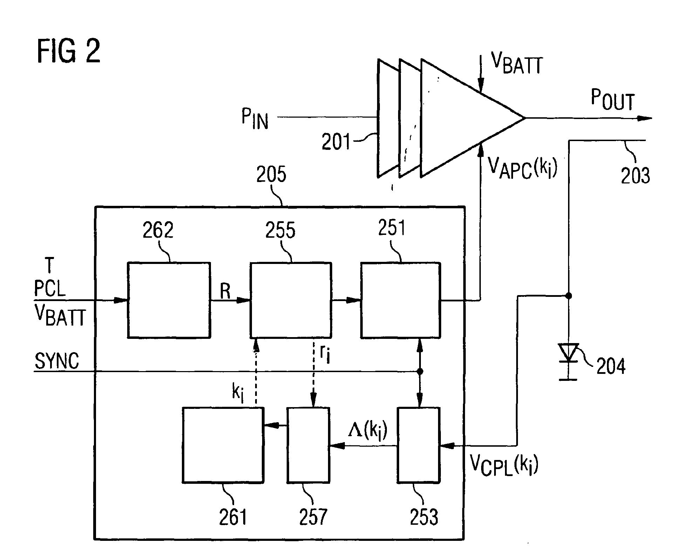

The invention is described in more detail with reference to examples in the accompanying drawings in Figures 1 and 2, of which:

Figure 1 illustrates the transfer characteristic ($P_{OUT}$ vs. $V_{APC}$) of a power amplifier; and

Figure 2 illustrates the device for measuring dependency of output power of a power amplifier on control voltage, and the device for setting the power ramp of a power amplifier.

**Detailed description of the invention**

Figure 1 illustrates the transfer characteristic $P_{OUT}(V_{APC})$, i.e. the relationship between the output power $P_{OUT}$ of a power amplifier and the control voltage $V_{APC}$ used to control the power amplifier. The transfer characteristic $P_{OUT}(V_{APC})$ has been sketched as three characteristics $c_1(T=T_1)$; $c_2(T=T_2)$, and $c_3(T=T_3)$, each in a different temperature T.

As can be seen from Figure 1, the transfer characteristics $c_1$, $c_2$, and $c_3$ are strongly temperature-dependent in the start-up power range 101. Especially, the control slope describing the sensitivity $\partial P_{OUT}(V_{APC})/\partial V_{APC}$ of the output power $P_{OUT}$ to a small change in the control voltage $V_{APC}$ changes depending on the temperature T, channel frequency CH, and supply voltage $V_{BATT}$.

The start-up power range 101 corresponds to output power from approximately -15 dBm to 5 dBm. This start-up power range 101 is characterized in high sensitivity of the power amplifier to changes in surrounding conditions, such as in temperature T, supply voltage $V_{BATT}$, or channel frequency CH, with a coinciding poor sensitivity of the detector used in obtaining the feed-back signal.

In a lower temperature (shown as $T_3$), the characteristic $c_3$ becomes steeper than in a higher temperature ($T_2$, $c_2$; $T_1$, $c_1$), and in order to have an amplification of 0 dBm, a higher control voltage $V_{APC}$ is required. The 0 dBm point is defined to be the control voltage $V_{APC}$ where the output power is 0 dBm.

In order to guarantee both a power and time template carrying data and a transient spectrum as required in the GSM specifications, the start-up range has to be controlled in a careful manner. An objective of the invention is to bring out a device and method that enables compensating for the sensitivity of the power amplifier to changes in environmental conditions, in such a manner that the data carried in the burst is not negatively affected.

Another range that is likewise critical is the saturation range 103. Also in the saturation range 103 there is a known parametrical dependency of output power on temperature T, supply power $V_{BATT}$, and frequency CH. More critical on this range is that the characteristic can change because of wrong termination of the final stage (e.g. because of antenna mismatch), resulting in significant reduction of saturation power. If now the output power is tried to be kept constant, the final stage is driven to more saturation, which then drastically increases the current and also degrades the transient spectrum.

In Figure 2, the operation of the device 205 for measuring dependency of output power of a power amplifier on control voltage, and for setting the power ramp of a power amplifier is explained in more detail.

The data to be transmitted is fed into the power amplifier 201 as input signal having an input power $P_{IN}$. The power amplifier 201 amplifies the input signal to an output signal having an output power $P_{OUT}$, usually by feeding current obtained from a rechargeable battery to a serie of transistors. The supply voltage $V_{BATT}$ is apt to drop after transmitting a larger number of bursts, because the charge capacity of a rechargeable battery is usually limited.

Because of transient considerations, the supply voltage $V_{BATT}$ is not usually switched but the gain of the power amplifier 201 is increased or decreased by applying a changing control voltage $V_{APC}$. This is one purpose for which the device 205 for setting the power ramp of a power amplifier 201 is used.

An example of power values $r_i$ of an up-ramp R is [in dBm] $r_1$ = -50; $r_2$ = -50; $r_3$ = -50; $r_4$ = -50; $r_5$ = -50; $r_6$ = -50; $r_7$ =-10; $r_8$ = -5; $r_9$ = 10; $r_{10}$ = 15; $r_{11}$ = 20; $r_{12}$ = 25; $r_{13}$ = 30; $r_{14}$ = 32; $r_{15}$ = 33; $r_{16}$ = 33. The value of -50 dBm corresponds to isolation by definition of the power values. With this ramp R the nominal value of power in a burst has to be 33 dBm. The shapes of up- and down-ramps R for each power class PCL are stored in register 262 which may be a look-up-table. For every power class PCL there is at least one ramp R available.

Power values $r_i$ of a ramp R cannot be passed to the power amplifier 201 as such, because the power amplifier 201 is adapted to receive a control voltage $V_{APC}$ but not a power value $r_i$. In order to make a feasible digital-to-analog conversion in a Digital-to-Analog Converter 251, the power values $r_i$ are mapped to key values $k_i$. With a 10-bit Digital-to-Analog Converter DAC 251 the key value $k_i$ obtains then any value between 0 and 1023, depending on the mapping schema used. The DAC 251 converts the key value $k_i$ to a control voltage $V_{APC}$ voltage. The key value $k_i$ = 1023 corresponds to a control voltage $V_{APC}$ = 1.8 V, for example.

As a consequence, a ramp R is mapped to a number of key values $k_i$. In some implementations, the number of key values $k_i$ in a ramp R is 16. For the isolation ($r_i$ = -50 dBm) a key value $k_i$ = 0 is selected.

In up- or down-ramping, the control voltage $V_{APC}$ of the power amplifier 201 is set responsive to all key values $k_i$ of the ramp R, the key values $k_i$ following each other in even time intervals, e.g. every 1.8 $\mu$s. The control voltage $V_{APC}$ corresponding to the last key value $k_{16}$ of the up-ramp R is sustained. The data-carrying part of a burst begins after setting the last key value $k_{16}$, so the last key value $k_{16}$ therefore defines the power in a burst. The form of the up- and down -ramps R can be controlled by selecting the key values $k_i$ inside the ramps R. Because the power amplifier 201 is affected by changes in its operating temperature T, supply voltage $V_{BATT}$, and channel frequency CH, in order to maintain the performance, the ramps $R$ are preferably not stored defined as key values $k_i$ but as power values $r_i$.

The mapping of power values $r_i$ of an up- or down-ramp $R$ to key values $k_i$ is obtained from register 261. Different mappings are preferably stored to be used in different environmental conditions, such as in different temperature T, different supply voltage $V_{BATT}$, and different channel frequency CH. The power values $r_i$ of an up- or down-ramp $R$ are mapped to corresponding key values $k_i$ in the mapping unit 255.

For GSM systems, it is advantageous that the register 261 covers the range from -15 dBm to 33 dBm in 0.25 dB steps. For different temperatures and voltage ranges there may be separate mappings in register 261.

Key value $k_i$ is passed into interpolation unit 257. The interpolation unit 257 comprises not only data about the mappings ($r_i$ -> $k_i$) stored in register 261, but also the detected output power $\Lambda(k_i)$ for each key value $k_i$.

The output power $P_{OUT}$ of the power amplifier 201 output is coupled using a coupler 203 and detected using a detector 204, such as a diode which also rectifies the coupled voltage $V_{CPL}$. The coupled voltage $V_{CPL}$ is sampled with an Analog-to-Digital Converter ADC 253 to produce detected output power $\Lambda(k_i)$. The conversion in ADC 253 is performed synchronously with the conversion in DAC 251, i.e. synchronously with conversion of a key value $k_i$ to control voltage $V_{APC}$, and therefore also synchronously to setting the up- or down-ramp. In this way, responsive to each key value $k_i$ of the up- or down-ramp $R$, i.e. for each sample value of the $V_{APC}$ voltage, a corresponding coupled voltage $V_{CPL}$ is obtained.

The resolution of the ADC 253, detector 204, and coupler 203 is so selected that a change in the output power $P_{OUT}$ caused by a change in the key value $k_i$ -> $k_j$ can be detected in a change in the detected output power from $\Lambda(k_i)$ to $\Lambda(k_j)$. Depending on the implementation, this may require that the separation between mapping between power value $r_i$ and key value $k_i$ in register 261 is small enough.

By performing measurements as described during up-ramping, detected output power $\Lambda(k_i)$ representing the power amplifier 201 characteristic $P(V_{APC})$ can be determined for the current environmental conditions (T, $V_{BATT}$, CH). The measurement is periodically repeated to amend the mapping between the power value $r_i$ and key value $k_i$ in order to compensate for changes in the transmission characteristics caused by changes in environmental conditions.

If an output power of 33 dBm is required from the power amplifier, the whole range of the detected output powers $\Lambda(k_i)$ will be gone through because the whole range of key values $k_i$ is also passed through, therefore causing the power amplifier 201 to pass through its whole power range.

The interpolation unit 257 computes an estimated dependency $\partial\Lambda(k_i)/\partial k$ of the detected output power $\Lambda(k_i)$ on a change in key value $k_i$. The estimated dependency $\partial\Lambda(k_i)/\partial k$ can be computed in many different ways known as such in numerical methods. The estimated dependency $\partial\Lambda(k_i)/\partial k$ can be computed from the detected output power $\Lambda(k_j)$ at at least two different key values, preferably, in order to increase numerical stability, selected from the set of $\{k_{i-2}, k_{i-1}, k_i, k_{i+1}, k_{i+2}\}$, with suitable weights that produce a true estimate. The mapping between power value $r_i$ and key value $k_i$ is updated into register 261 based on the estimate of sensitivity $\partial\Lambda(k_i)/\partial k$ for other key values $k_i$ not inside the measurement range.

After obtaining the mapping between the detected output power $\Lambda(k_i)$ and key value $k_i$ for all key values in the ramp R, in the next step the complete mapping ($r_i$ -> $k_i$) is interpolated based on the measurement results. After the interpolation, the mapping ($r_i$ -> $k_i$) is stored in register 261. In this way, for current environment conditions, an actualized mapping ($r_i$ -> $k_i$) is available and it can be used for the next burst for mapping the power values $r_i$ to the key values $k_i$. The interpolation can be simply linear. However, especially advantageous in this case is the cubic spline interpolation.

The described procedure alone does not necessarily guarantee a good enough power and time template for carrying data, nor does it guarantee a good enough transient spectrum. Critical for the transient spectrum are the start-up power range 101 and the saturation range 103. The start-up power range 101 from -15 dBm to 0 dBm has an essential impact on the transient spectrum.

Therefore, the mappings in register 261 cover also the start-up power range 101. Detectors 204, such as diodes, are not sufficiently sensitive in the start-up power range 101 if the usual dimensioning of the coupler 203 is followed. Thus, the detected output power $\Lambda(k_i)$ is extrapolated for those key values $k_i$ that belong to the start-up power range 101, using an estimate of sensitivity $\partial\Lambda(k_j)/\partial k$ at some other key value $k_j$ not belonging to the start-up power range 101, together with the detected output power $\Lambda(k_j)$ for key value $k_j$:

$$\Lambda(k_i) = \Lambda(k_j) + \partial\Lambda(k_j)/\partial k \quad \partial(k_i - k_j).$$

Because the power amplifier 201 characteristic $P_{OUT}(V_{APC})$ in the start-up power range 101 is mostly linear, a simple, linear extrapolation will do. By extending the mapping below the sensing range of the detector 204, up- and down-ramping is possible with a defined form of the ramp.

In addition to the start-up power range 101, the saturation range 103 is also critical. Especially under mismatch conditions, the saturation power of the power amplifier 201 is significantly reduced. If such a power value $r_i$ that requires more power from the power amplifier 201 than it can deliver, e.g. because of current load conditions, is given within the ramp $R$, the transient spectrum is degraded. This case has to be avoided. In order to solve this problem, the following method is proposed. The register 261 comprises mapping between the detected output power $\Lambda(k_i)$ for each key value $k_i$. If, in addition to the detected output power $\Lambda(k_i)$ also an estimate of sensitivity $\partial\Lambda(k_i)/\partial k$ of the detected output power $\Lambda(k_i)$ from key value $k_i$ is stored, an easy detecting of the saturation can be enabled.

The key value $k_{LIMIT}$ where the power amplifier 201 reaches the saturation range 103 can be detected from the characteristic of detected power $\Lambda(k_i)$ that has a substantially similar shape as the characteristics of Figure 1, i.e. $P_{OUT}(V_{APC})$. The key value $k_{LIMIT}$ causing entering to the saturation range 103 is the point at which the dependency $\partial\Lambda(k_i)/\partial k$ drops below a predefined threshold. The power value $r_{LIMIT}$ corresponding to the key value $k_{LIMIT}$ is passed to the mapping unit 255.

After selecting ramp $R$ from register 262, if any of the power values $r_i$ of the ramp $R$ exceeds the power value $r_{LIMIT}$. If there is any power value $r_i$ present exceeding the predefined power value $r_{LIMIT}$, the mapping unit 255 selects another ramp $R_{NEW}$ from the register 262 for which the maximum power value $r_{MAX}$ does not exceed the predefined power value $r_{LIMIT}$.

In this manner it can be guaranteed that the actual ramp that is passed to the power amplifier 201 has the desired form. Without this mechanism, the output power $P_{OUT}$ above the saturation power $P_{SAT}$ would show an abrupt transition during ramping up, thereby degrading the transient spectrum.

The method and device can be used in devices operating in such mobile radio networks that support the GSM standard, for example. The described method and the arrangement are suitable also for EDGE architectures, because there is only amplitude modulation with a small ripple during ramping.

The number of bits in the DAC and ADC is arbitrary. Basically, converters using 10, 12, 14, 16, or 18 bits are most widely used. Furthermore, the control voltage does not need to be 1,8 V, but any other voltage can do. The timing between key values $k_i$ are converted to control voltages $V_{APC}$ depends on the system used and does not need to be 1,8 $\mu$s (which would be used for 900 MHz) but any synchronization can be used, such as 0,9 $\mu$s (e.g. for MHz systems).

In order to increase the stability of the measurements, the measurements can be performed for a number (e.g. 10 times) of consecutive bursts and then averaged.

Furthermore, the invention is not limited to the simple examples used to clarify the invention, but to the scope of the claims.

## Claims

1. A device (205) for measuring dependency of output power ($P_{OUT}$) of a power amplifier (201) on control voltage ($V_{APC}$), comprising:

   - means (203, 204) for receiving a voltage ($V_{CPL}$) coupled to an output signal of the power amplifier (201);
   - converting means (253) adapted to convert the received voltage ($V_{CPL}$) to detected output power $\Lambda(k_i)$ synchronously to setting means (251) setting a power amplifier (201) control voltage ($V_{APC}$), when the setting means (251) are adapted to perform up- or down-ramping of the power amplifier (201); and
   - means (257) for generating or updating a predefined mapping rule (261) which maps a power value ($r_i$) representing the output power ($P_{OUT}$) into a key value ($k_i$) fed to setting means (251) as control input after the completion of up- or down-ramping of the power amplifier (201);

   **characterized in that** the device (205) further comprises:

   an interpolation unit (257) adapted to interpolate said key valve ($k_i$) for said power value ($v_i$) representing the output power ($P_{OUT}$) between two key values ($k_i$) for which detected output power ($\Lambda(k_i)$) has been measured by using an estimate ($\partial\Lambda(k_i)/\partial k$) for dependency of the detected output power ($\Lambda(k_i)$) on the key value ($k_i$).

2. A device (205) according to claim 1, further **comprising:** a unit (257) adapted to use an estimate ($\partial\Lambda(k_i)/\partial k$) for dependency of the detected output power ($\Lambda(k_i)$) on the key value ($k_i$) in order to extrapolate a key value ($k_i$) for a power value ($r_i$) representing output power ($P_{OUT}$) below the dynamic range of the means (203, 204) for receiving the voltage ($V_{CPL}$), or of the converting means (253).

3. A device (205) according to any one of the preceding claims, further **comprising:** means (257) adapted to detect saturation of the power amplifier (201) by comparing an estimated dependency ($\partial\Lambda(k_i)/\partial k$) of the detected output power ($\Lambda(k_i)$) on the key value ($k_i$) with a predefined threshold value.

**4.** A device (205) according to claim 3, **wherein:** the means (257) is further adapted to return a power value ($r_{LIMIT}$) that causes saturation of the power amplifier (201).

**5.** A device (205) for generating an up- or down ramp (R) for a power amplifier (201), comprising:

- means (262) for receiving a power class (PCL) and for selecting a ramp (R) responsive to the power class (PCL);
- means (255, 251) for mapping said ramp (R) to a series of control voltages ($V_{APC}$) of the power amplifier (201) synchronously to a system timer (SYNC);

**characterized in that**:
the means (255, 251) for mapping said ramp (R) to a series of control voltages ($V_{APC}$) are adapted to receive a mapping ($r_i \rightarrow k_i$) from a device (205) according to any one of claims 1 to 4.

**6.** A device (205) according to any one of the preceding claims 1 to 5, **characterized in that**:

- the device (205) is further adapted to receive a temperature (T), supply voltage ($V_{BATT}$), and a channel frequency (CH); and
- the predefined mapping rule (261, 257) is further adapted to change the mapping responsive to a change in the temperature (T), supply voltage ($V_{BATT}$), or channel frequency (CH).

**7.** A method for measuring dependency of output power ($P_{OUT}$) of a power amplifier (201) on control voltage ($V_{APC}$), comprising the steps of:

- receiving a voltage ($V_{CPL}$) coupled to output signal of the power amplifier (201);
- converting the received voltage ($V_{CPL}$) to detected output power $\Lambda(k_i)$ synchronously to setting a power amplifier (201) control voltage ($V_{APC}$), when the setting means (251) are adapted to perform up- or down-ramping of the power amplifier (201); and
- generating or updating a predefined mapping rule (257, 261) which maps a power value ($r_i$) representing the output power ($P_{OUT}$) into a key value ($k_i$) fed to the setting means (251) as control input after the up- or down-ramping of the power amplifier (201) has been completed;

**wherein** the method comprises the step of
interpolating said key value ($k_i$) for said power value ($r_i$) representing the output power ($P_{OUT}$) between two key values ($k_i$) for which detected output power ($\Lambda(k_i)$) has been measured by using an estimate ($\partial\Lambda(k_i)/\partial k$) for dependency of the detected output power ($\Lambda(k_i)$) on the key value ($k_i$).

**8.** A method according to claim 7, further **comprising the step of:** extrapolating a key value ($k_i$) for an output power ($P_{OUT}$) below the dynamic range of means (203, 204) for receiving the voltage ($V_{CPL}$), or of converting means (253) by using an estimate ($\partial\Lambda(k_i)/\partial k$) for dependency of the detected output power ($\Lambda(k_i)$) on the key value ($k_i$).

**9.** A method according to claim 7 to 8, further **comprising the step of:** detecting saturation of the power amplifier (201) by comparing an estimated dependency ($\partial\Lambda(k_i)/\partial k$) of the detected output power ($\Lambda(k_i)$) on the key value ($k_i$) with a predefined threshold value.

**10.** A method according to claim 9, **wherein:** a power value ($r_{LIMIT}$) that causes saturation of the power amplifier (201) is returned.

**11.** A method for generating an up- or down-ramp (R) for a power amplifier (201), comprising the steps of:

- receiving a power class (PCL) and for selecting a ramp (R) responsive to the power class (PCL);
- mapping said ramp (R) to a series of control voltages ($V_{APC}$) of the power amplifier (201), adapted to work in synchronization with a system timer (SYNC);

**characterized in that**:
the mapping step is performed using a mapping ($r_i \rightarrow k_i$) from a predefined mapping rule (255, 257) obtained with a method according to any one claims 9 to 10.

**12.** A method according to any one of the preceding claims 7 to 11, **characterized in that**:

the predefined mapping rule (261, 257) is further adapted to change the mapping responsive to a change in the temperature (T), supply voltage ($V_{BATT}$), or channel frequency (CH).

**Patentansprüche**

1. Schaltungsanordnung (205) zur Messung der Abhängigkeit der Ausgangsleistung ($P_{OUT}$) eines Leistungsverstärkers (201) von der Steuerspannung ($V_{APC}$), welche Folgendes umfasst:

   - Mittel (203, 204) zum Empfangen einer Spannung ($V_{CPL}$) gekoppelt an ein Ausgangssignal des Leistungsverstärkers (201);
   - Umwandlungsmittel (253) zum Umwandeln der empfangenen Spannung ($V_{CPL}$) in eine gemessene Ausgangsleistung $\Lambda(k_i)$ synchron mit Einstellungsmitteln (251), die eine Steuerspannung ($V_{APC}$) für den Leistungsverstärker (201) einstellen, wenn die Einstellungsmittel (251) dafür ausgelegt sind, einen Anstieg oder Abfall des Leistungsverstärkers (201) auszuführen; und
   - Mittel (257) zum Erzeugen oder Aktualisieren einer vorab definierten Zuordnungsregel (261), welche einen Leistungswert ($r_i$), der die Ausgangsleistung ($P_{OUT}$) repräsentiert, einem Schlüsselwert ($k_i$) zuordnet, der in das Einstellungsmittel (251) eingespeist wird als Steuereingang nach Abschluss der Anstiegs- bzw. Abfall-Phase des Leistungsverstärkers (201);

   **dadurch gekennzeichnet, dass** die Schaltungsanordnung (205) ferner Folgendes umfasst:

   eine Interpolationseinheit (257), die dafür ausgelegt ist, den besagten Schlüsselwert ($k_i$) für den besagten Leistungswert ($r_i$), welcher die Ausgangsleistung ($P_{OUT}$) zwischen zwei Schlüsselwerten ($k_i$) repräsentiert, für die die gemessene Ausgangsleistung ($\Lambda(k_i)$) gemessen worden ist, zu interpolieren, wozu ein Schätzwert ($\partial\Lambda(k_i)/\partial k$) für die Abhängigkeit der gemessenen Ausgangsleistung ($\Lambda(k_i)$) von dem Schlüsselwert ($k_i$) verwendet wird.

2. Schaltungsvorrichtung (205) gemäß Anspruch 1, welche ferner Folgendes umfasst: eine Einheit (257), die dafür ausgelegt ist, einen Schätzwert ($\partial\Lambda(k_i)/\partial k$) für die Abhängigkeit der gemessenen Ausgangsleistung ($\Lambda(k_i)$) von dem Schlüsselwert ($k_i$) zu verwenden, um einen Schlüsselwert ($k_i$) für einen Leistungswert ($r_i$), welcher eine Ausgangsleistung ($P_{OUT}$) unterhalb des Dynamikbereichs der Mittel (203, 204) zum Empfangen der Spannung ($V_{CPL}$) oder des Umwandlungsmittels (253) repräsentiert, zu extrapolieren.

3. Schaltungsanordnung (205) gemäß einem der vorstehenden Ansprüche, welche ferner Folgendes umfasst: Mittel (257), das dafür ausgelegt ist, die Sättigung des Leistungsverstärkers (201) zu erkennen, indem eine geschätzte Abhängigkeit ($\partial\Lambda(k_i)/\partial k$) der gemessenen Ausgangsleistung ($\Lambda(k_i)$) von dem Schlüsselwert ($k_i$) mit einem vorab definierten Schwellenwert verglichen wird.

4. Schaltungsanordnung (205) gemäß Anspruch 3, wobei: das Mittel (257) ferner dafür ausgelegt ist, einen Leistungswert ($r_{LIMIT}$) zurückzuliefern, der die Sättigung des Leistungsverstärkers (201) herbeiführt.

5. Schaltungsanordnung (205) zum Erzeugen eines ansteigenden bzw. abfallenden Rampensignals (R) für einen Leistungsverstärker (201), welche Folgendes umfasst:

   - Mittel (262) zum Empfangen einer Leistungsklasse (PCL) sowie zum Auswählen eines Rampensignals (R) als Reaktion auf die Leistungsklasse (PCL);
   - Mittel (255, 251) zum Zuordnen des besagten Rampensignals (R) zu einer Reihe von Steuerspannungen ($V_{APC}$) des Leistungsverstärkers (201) synchron mit einem Systemzeitgeber (SYNC);

   **dadurch gekennzeichnet, dass**:
   die Mittel (255, 251) zum Zuordnen des besagten Rampensignals (R) zu einer Reihe von Steuerspannungen ($V_{APC}$) dafür ausgelegt sind, eine Zuordnung ($r_i$ -> $k_i$) von einer Schaltungsanordnung (205) gemäß einem der vorstehenden Ansprüche 1 bis 4 zu empfangen.

6. Schaltungsanordnung (205) gemäß einem der vorstehenden Ansprüche 1 bis 5, **dadurch gekennzeichnet, dass**:

   - die Schaltungsanordnung (205) ferner dafür ausgelegt ist, eine Temperatur (T), eine Versorgungsspannung

($V_{BATT}$) und eine Kanalfrequenz (CH) zu empfangen; und
- die vorab definierte Zuordnungsregel (261, 257) ferner dafür ausgelegt ist, die Zuordnung als Reaktion auf eine Veränderung der Temperatur (T), der Versorgungsspannung ($V_{BATT}$) oder der Kanalfrequenz (CH) zu ändern.

7. Verfahren zur Messung der Abhängigkeit der Ausgangsleistung ($P_{OUT}$) eines Leistungsverstärkers (201) von der Steuerspannung ($V_{APC}$), welches folgende Schritte umfasst:

- Empfangen einer Spannung ($V_{CPL}$) gekoppelt mit dem Ausgangssignal des Leistungsverstärkers (201);
- Umwandeln der empfangenen Spannung ($V_{CPL}$) in eine gemessene Ausgangsleistung $\Lambda(k_i)$ synchron zum Einstellen einer Steuerspannung ($V_{APC}$) für den Leistungsverstärker (201), wenn die Einstellungsmittel (251) dafür ausgelegt sind, einen Anstieg oder Abfall des Leistungsverstärkers (201) auszuführen; und
- Erzeugen oder Aktualisieren einer vorab definierten Zuordnungsregel (257, 261), welche einen Leistungswert ($r_i$), der die Ausgangsleistung ($P_{OUT}$) repräsentiert, einem Schlüsselwert ($k_i$) zuordnet, der in das Einstellungsmittel (251) eingespeist wird als Steuereingang nach Abschluss der Anstiegs- bzw. Abfall-Phase des Leistungsverstärkers (201);

wobei das Verfahren folgenden Schritt umfasst:

Interpolieren des besagten Schlüsselwertes ($k_i$) für den besagten Leistungswert ($r_i$), welcher die Ausgangsleistung ($P_{OUT}$) zwischen den besagten zwei Schlüsselwerten ($k_i$) repräsentiert, für die die gemessene Ausgangsleistung ($\Lambda(k_i)$) gemessen worden ist, wozu ein Schätzwert ($\partial\Lambda(k_i)/\partial k$) für die Abhängigkeit der gemessenen Ausgangsleistung ($\Lambda(k_i)$) von dem Schlüsselwert ($k_i$) verwendet wird.

8. Verfahren gemäß Anspruch 7, welches ferner folgenden Schritt umfasst: Extrapolieren eines Schlüsselwertes ($k_i$) für eine Ausgangsleistung ($P_{OUT}$) unterhalb des Dynamikbereichs der Mittel (203, 204) zum Empfangen der Spannung ($V_{CPL}$) oder des Umwandlungsmittels (253), wozu ein Schätzwert ($\partial\Lambda(k_i)/\partial k$) für die Abhängigkeit der gemessenen Ausgangsleistung ($\Lambda(k_i)$) von dem Schlüsselwert ($k_i$) verwendet wird.

9. Verfahren gemäß Anspruch 7 bis 8, welches ferner folgenden Schritt umfasst: Erkennen der Sättigung des Leistungsverstärkers (201), indem eine geschätzte Abhängigkeit ($\partial\Lambda(k_i)/\partial k$) der gemessenen Ausgangsleistung ($\Lambda(k_i)$) von dem Schlüsselwert ($k_i$) mit einem vorab definierten Schwellenwert verglichen wird.

10. Verfahren gemäß Anspruch 9, wobei: ein Leistungswert ($r_{LIMIT}$), der die Sättigung des Leistungsverstärkers (201) herbeiführt, zurückgeliefert wird.

11. Verfahren zum Erzeugen eines ansteigenden bzw. abfallenden Rampensignals (R) für einen Leistungsverstärker (201), welches folgende Schritte umfasst:

- Empfangen einer Leistungsklasse (PCL) sowie Auswählen eines Rampensignals (R) als Reaktion auf die Leistungsklasse (PCL);
- Zuordnen des besagten Rampensignals (R) zu einer Reihe von Steuerspannungen ($V_{APC}$) des Leistungsverstärkers (201) synchron mit einem Systemzeitgeber (SYNC);

**dadurch gekennzeichnet, dass**:
der Schritt des Zuordnens ausgeführt wird, indem eine Zuordnung ($r_i$ -> $k_i$) aus einer vorab definierten Zuordnungsregel (255, 257), welche mit einem Verfahren gemäß einem der Ansprüche 9 bis 10 beschafft wurde, verwendet wird.

12. Verfahren gemäß einem der vorstehenden Ansprüche 7 bis 11, **dadurch gekennzeichnet, dass**:

die vorab definierte Zuordnungsregel (261, 257) ferner dafür ausgelegt ist, die Zuordnung als Reaktion auf eine Veränderung der Temperatur (T), der Versorgungsspannung ($V_{BATT}$) oder der Kanalfrequenz (CH) zu ändern.

**Revendications**

1. Dispositif (205) pour mesurer la dépendance de la puissance de sortie ($P_{OUT}$) d'un amplificateur de puissance (201) vis-à-vis de la tension de contrôle ($V_{APC}$), comprenant :

des moyens (203, 204) pour recevoir une tension ($V_{CPL}$) couplée à un signal de sortie de l'amplificateur de puissance (201),

des moyens de conversion (253) adaptés pour convertir la tension reçue ($V_{CPL}$) en une puissance de sortie détectée ($\Lambda(k_i)$) et ce de manière synchrone avec des moyens de réglage (251) qui règle la tension de contrôle ($V_{APC}$) de l'amplificateur de puissance (201) lorsque les moyens de réglage (251) sont adaptés pour réaliser la montée et la descente en puissance par rampe de l'amplificateur de puissance (201) et

des moyens (257) pour créer ou mettre à jour une règle de mappage (261) prédéfinie qui mappe une valeur de puissance ($r_i$) qui représente la puissance de sortie ($P_{OUT}$), une valeur clé ($k_i$) introduite dans les moyens de réglage (251) comme entrée de contrôle après la réalisation de la montée ou de la descente en puissance par rampe de l'amplificateur de puissance (201),

**caractérisé en ce que** le dispositif (205) comprend en outre :

une unité d'interpolation (257) adaptée pour interpoler ladite valeur clé ($k_i$) pour ladite valeur de puissance ($r_i$) qui représente la puissance de sortie ($P_{OUT}$) entre deux valeurs clés ($k_i$) pour lesquelles la puissance de sortie détectée ($\Lambda(k_i)$) a été mesurée en utilisant une estimée ($\partial\Lambda(k_i) / \partial k$) de la dépendance de la puissance de sortie détectée ($\Lambda(k_i)$) vis-à-vis de la valeur clé ($k_i$).

2. Dispositif (205) selon la revendication 1, qui comprend en outre une unité (257) adaptée pour utiliser une estimée ($\partial\Lambda(k_i) / \partial k$) de la dépendance de la puissance de sortie détectée ($\Lambda(k_i)$) vis-à-vis de la valeur clé ($k_i$) pour extrapoler une valeur clé ($k_i$) d'une valeur de puissance ($r_i$) qui représente la puissance de sortie ($P_{OUT}$) en dessous de la plage dynamique des moyens (203, 204) de réception de la tension ($V_{CPL}$) ou des moyens de conversion (253).

3. Dispositif (205) selon l'une quelconque des revendications précédentes, qui comprend en outre des moyens (257) adaptés pour détecter la saturation de l'amplificateur de puissance (201) en comparant la dépendance estimée ($\partial\Lambda(k_i) / \partial k$) de la puissance de sortie détectée ($\Lambda(k_i)$) vis-à-vis de la valeur clé ($k_i$) à une valeur de seuil prédéfinie.

4. Dispositif (205) selon la revendication 3, dans lequel les moyens (257) sont en outre adaptés pour renvoyer une valeur de puissance ($r_{LIMIT}$) qui amène la saturation de l'amplificateur de puissance (201).

5. Dispositif (205) de création d'une rampe montante ou descendante (R) d'un amplificateur de puissance (201) qui comprend:

des moyens (262) de réception d'une classe de puissance (PCL) et de sélection d'une rampe (R) en réponse à la classe de puissance (*PCL*),

des moyens (255, 251) qui mappent ladite rampe (R) en une série de tensions de contrôle ($V_{APC}$) de l'amplificateur de puissance (201) de manière synchrone avec une horloge système (SYNC),

**caractérisé en ce que** :

les moyens (255, 251) de mappage de ladite rampe (R) en une série de tensions de contrôle ($V_{APC}$) sont adaptés pour recevoir un mappage ($r_i \rightarrow k_i$) d'un dispositif (205) selon l'une quelconque des revendications 1 à 4.

6. Dispositif (205) selon l'une quelconque des revendications 1 à 5 qui précèdent, **caractérisé en ce que** :

le dispositif (205) est en outre adapté pour recevoir une température (T), une tension d'alimentation ($V_{BATT}$) et une fréquence de canal (CH) et

la règle de mappage (261, 257) prédéfinie est en outre adaptée pour modifier le mappage en réponse à une modification de la température (T), de la tension d'alimentation ($V_{BATT}$) ou de la fréquence de canal (CH).

7. Procédé pour mesurer la dépendance de la puissance de sortie ($P_{OUT}$) d'un amplificateur de puissance (201) vis-à-vis de la tension de contrôle ($V_{APC}$), qui comprend les étapes de :

recevoir une tension ($V_{CPL}$) couplée à un signal de sortie de l'amplificateur de puissance (201),

convertir la tension ($V_{CPL}$) reçue en une puissance de sortie détectée ($\Lambda(k_i)$) de manière synchronisée par rapport au réglage de la tension de contrôle ($V_{APC}$) de l'amplificateur de puissance (201) lorsque les moyens de réglage (251) sont adaptés pour réaliser la montée ou la descente en puissance par rampe de l'amplificateur de puissance (201) et

créer ou mettre à jour une règle prédéfinie de mappage (257, 261) qui mappe une valeur de puissance ($r_i$) qui représente la puissance de sortie ($P_{OUT}$) en une valeur clé ($k_i$) introduite dans les moyens de réglage (251) comme entrée de contrôle après que la montée ou la descente en puissance par rampe de l'amplificateur de puissance (201) ait terminé,

dans lequel le procédé comprend l'étape d'interpolation de ladite valeur clé ($k_i$) pour ladite valeur de puissance ($r_i$) qui représente la puissance de sortie ($P_{OUT}$) entre les deux valeurs clés ($k_i$) pour lesquelles la puissance de sortie détectée ($k_i$) a été mesurée en utilisant une estimée ($\partial \Lambda(k_i) / \partial k$) de la dépendance de la puissance de sortie détectée (($\Lambda(k_i)$) vis-à-vis de la valeur clé ($k_i$).

8. Procédé selon la revendication 7, qui comprend en outre l'étape d'extrapolation d'une valeur clé ($k_i$) pour une puissance de sortie ($P_{OUT}$) en dessous de la plage dynamique des moyens (203, 204) de réception de la tension ($V_{CPL}$) ou des moyens de conversion (253) en utilisant une estimée ($\partial \Lambda(k_i) / \partial k$) de la dépendance de la puissance de sortie détectée ($\Lambda(k_i)$) vis-à-vis de la valeur clé ($k_i$).

9. Procédé selon les revendications 7 à 8, qui comprend en outre l'étape de détection de la saturation de l'amplificateur de puissance (201) en comparant la dépendance estimée ($\partial \Lambda(k_i) / \partial k$) de la puissance de sortie détectée ($\Lambda(k_i)$) vis-à-vis de la valeur clé ($k_i$) à une valeur de seuil prédéfinie.

10. Procédé selon la revendication 9, dans lequel la valeur de puissance ($r_{LIMIT}$) qui amène la saturation de l'amplificateur de puissance (201) est renvoyée.

11. Procédé de création d'une rampe montante ou descendante ($R$) pour un amplificateur de puissance (201), qui comprend les étapes de :

recevoir une classe de puissance (*PCL*) et sélectionner une rampe ($R$) en réponse à la classe de puissance (PCL),
mapper ladite rampe ($R$) en une série de tensions de contrôle ($V_{APC}$) de l'amplificateur de puissance (201) adaptées pour travailler en synchronisation avec une horloge système (SYNC),

**caractérisé en ce que** :

l'étape de mappage est réalisée en utilisant un mappage ($r_i \rightarrow k_i$) obtenue à partir d'une règle prédéfinie de mappage (255, 257) obtenue à l'aide d'un procédé selon l'une quelconque des revendications 9 à 10.

12. Procédé selon l'une quelconque de revendications 7 à 11 qui précèdent, **caractérisé en ce que** la règle de mappage prédéfinie (261, 257) est en outre adaptée pour modifier le mapapge en réponse à une modification de la température (T) de la tension d'alimentation ($V_{BATT}$) ou de la fréquence de canal (CH).

# FIG 1

# FIG 2